# EUROPÄISCHE PATENTSCHRIFT

(11) **EP 1 561 837 B1**
(45) Veröffentlichungstag und Bekanntmachung des Hinweises auf die Patenterteilung: **16.08.2006**
(21) Anmeldenummer: 04003574.3
(22) Anmeldetag: 18.02.2004
(51) Int. Cl.: C23C 14/56

(54) **Bandbeschichtungsanlage mit einer Vakuumkammer und einer Beschichtungswalze**
Strip coating installation with a vacuum chamber and a coating cylinder
Installation de revêtement des bandes avec une chambre à vide et un cylindre de revêtement

(30) Priorität: 07.02.2004 DE 10206131
(43) Veröffentlichungstag der Anmeldung: 10.08.2005
(73) Patentinhaber: Applied Films GmbH & Co. KG, 63755 Alzenau (DE)
(72) Erfinder: Hein, Stefan Dipl.-Ing., 63825 Blankenbach (DE); Skuk, Peter Dipl.-Ing., 61130 Nidderau (DE)
(74) Vertreter: Zapfe, Hans

(56) Entgegenhaltungen:
- WO-A-98/11271
- WO-A-99/50472
- WO-A-03/046251
- US-A- 4 692 233

## Beschreibung

Die Erfindung betriff eine Bandbeschichtungsanlage mit einer Vakuumkammer, die zwischen einer Rückwand und mindestens einer abnehmbaren Verschlussplatte eine Zarge mit einer ebenen Decke besitzt, wobei in der Vakuumkammer mindestens eine Leitwalze und eine Beschichtungswalze mit einer Achse sowie mindestens eine Beschichtungsquelle angeordnet sind.

Als Bänder bzw. Substrate kommen hierbei Folien als Metallen und Kunststoffen, Papier und/oder Verbundmaterialien hieraus infrage. Als Beschichtungsquellen kommen beispielhaft Verdampfer, Zerstäubungskatoden mit und ohne Magnetfeldverstärkung, Gasquellen etc. infrage, wobei durch Zufuhr von neutralen bzw. inerten und/oder reaktiven Gasen metallische und oder oxidische Schichten und Schichtpakete aus mehreren Schichten erzeugt werden können. Herkömmliche Verfahren sind das PVD-Verfahren (physical vapour deposition), PCVD-Verfahren (physical-chemical vapour deposition). Auch Vorbehandlungen der Bänder und Nachbehandlungen der Schichten durch bekannte Reaktionen sind möglich. Produktbeispiele sind in der Beschreibung abgehandelt, aber nicht erschöpfend dargestellt.

Durch die US 4 692 233 A ist eine Bandbeschichtungsanlage bekannt, bei der beiderseits einer zylindrischen Zarge einer Vakuumkammer Fahrgestelle mit Verschlusswänden angeordnet sind. Das eine Fahrgestell trägt in fliegender Lagerung ein Wickel system mit einer zentralen Beschichtungswalze, Ab- und Aufwickelwalzen für das zu beschichtende bzw. beschichtete Band sowie eine Anzahl von Leitwalzen für die faltenfreie Bandführung. Das andere Fahrgestell trägt ebenfalls in fliegender Lagerung ein Beschichtungssystem mit drei Beschichtungsquellen. Unterhalb einer waagrechten Mittenebene, in der die Achse der Beschichtungswalze liegt, befinden sich drei sektorförmige Teilkammern. Dadurch werden auf dem Umfang der Beschichtungswalze vier Teilkammern gebildet, von denen jede an eine eigene Vakuumpumpe angeschlossen ist. Beim Zusammenfahren der Anlage wird von der einen Seite das Wickelsystem, und von der gegenüber liegenden Seite wird das Beschichtungssystem eingefahren

Für solche Anlagentypen gilt grundsätzlich: Es muss durch entsprechende Führungen, z.B. Schienen, dafür Sorge getragen werden, dass sich die Teile nicht nur nicht berühren, sondern auch genau vorgegebene Positionen einnehmen. Dabei bilden bereits die Trennwände zwischen den Teilkammern ein Problem, die einerseits eine gute Abdichtwirkungen der Teilkammern untereinander herbeiführen sollen, andererseits aber das Band nicht berühren dürfen. Man hat sich beim Gegenstand der US 4 692 233 A daher so beholfen, die Trennwände von innen nach aussen dreiteilig auszubilden, die inneren Teile am fahrbaren Wickelgestell zu befestigen, die äusseren Teile mit der Zarge der Vakuumkammer zu verschweissen und dazwischen elastomere Gleitdichtungen anzuordnen. Die Abdichtung gegenüber den Enden der Beschichtungswalze gelingt damit aber äusserst unvollkommen. Dabei ist der Platzbedarf beiderseits der Vakuumkammer wegen der Fahrbewegungen der Einbauteile enorm. übermässig gross ist aber auch die Bauhöhe, weil die Ab- und Aufwickelwalzen oberhalb der Beschichtungswalze liegen. Die üblichen Bauhöhen solcher Anlagen liegen zwischen etwa 3,5 und 4 Metern. Hinzu kommt, dass sämtlicher Abrieb von Partikeln durch die Vielzahl der Beweglichen Teile in der oberen Kammer eine Gefahrenquelle ersten Ranges für die Schichtqualität darstellt.

Durch die DE 42 07 525 C2 ist es bei einer ähnlichen Anlage bekannt, das Beschichtungssystem ortsfest in einer Vakuumkammer anzuordnen und das Wickelsystem ausfahrbar zu gestalten, und zwar am einen Ende aufgehängt an einer Deckenschiene der Vakuumkammer und am anderen Ende abgestützt auf einem Schienenfahrzeug. Eine Deckenschiene in einer Vakuumkammer ist wiederum eine Ursache für unerwünschten Abrieb, und das Problem der Bauhöhe ist in etwa das gleiche.

Durch den Aufsatz von Langlois u.a. "Engineering Solutions Enabling a New Family of Expandable Multi-Process, Multi-Chamber Vacuum Roll Coaters", veröffentlicht 1999 von der Society of Vacuum Coaters, ISSN 0737-5921, Seiten 475 bis 479, ist die umgekehrte Lösung bekannt, das Wickelsystem ständig in einer unbeweglichen Vakuumkammer zu belassen und die Beschichtungssysteme zu Wartungs- und Reinigungszwecken ausfahrbar zu gestalten. Um fliegende Lagerungen der Walzen des Wickelssystems zu vermeiden, sind die Lagerstellen an einem Ende in einem Stützkörper gelagert, der in etwa die Form eines "Y" mit einer starken kreisförmigen Ausbauchung im Bereich der Beschichtungswalze hat. Dieser Stützkörper ist an seinem unteren Ende über ein Winkelstück mit dem Boden der Vakuumkammer verschraubt und blockiert damit eine sehr wesentliche Stelle für die Unterbringung einer mittigen Beschichtungsquelle. Ähnliches gilt für einen jenseitigen Stützkörper, von dem allerdings nur der rechte Verschraubungsfuss sichtbar ist. Aus der Gesamtansicht mit der Laufschiene für eine Kranbrücke ergibt sich auch hier, dass die gesamte Bauhöhe den Wert von 3,5 bis 4 Metern ohne weiteres übersteigen dürfte.

Die DE 101 57 186 C1 offenbart eine Bandbeschichtungsanlage mit einer mittigen Kammer, in der sich ein Prozesswalzenstuhl mit zwei Beschichtungswalzen befindet. Dieser stützt sich auf Traversen an zwei Innenwänden ab, die die Stützlast jedoch nur nach unten zum Boden übertragen können, weil eben diese Innenwände im Bereich ihrer oberen Enden als Bandventile bezeichnete Durchtrittsspalte für das Bandmaterial besitzen. Diese Durchtrittsspalte nehmen fast die gesamte Breite der Anlage ein, so dass die Decke nicht als Trägerin für den Prozesswalzenstuhl in Frage kommt. über dessen Beweglichkeit und die Gesamtbauhöhe schweigt sich diese Schrift aus.

Der Erfindung liegt daher die Aufgabe zugrunde, eine Bandbeschichtungsanlage der eingangs beschriebenen Gattung mit mehreren Kammern anzugeben, die eine möglichst geringe Bauhöhe aufweist, bei gegebener Bandbreite auch eine möglichst geringe Breite besitzt, bei der der Bandlaufweg in geöffnetem Zustand, d.h., bei ausgefahrenen Beschichtungsquellen gut einsehbar und kontrollierbar ist, bei der sich oberhalb der Beschichtungswalze eine geringstmögliche Zahl von beweglichen, Partikel verursachenden Teilen befindet, die sich gut transportieren lässt und die auch in Reinräumen beschränkter Abmessungen eingesetzt werden kann. Schliesslich soll auch eine möglichst wirksame Abschottung der einzelnen Kammern gegeneinander erreicht werden, wobei auch Nebenwege für solche Strömungen über die Stirnseiten der Beschichtungswalze so weit wie möglich ausgeschaltet werden sollen.

Die Partikelfreiheit ist insbesondere für die nachstehenden Anwendungen unerlässlich:
a) Kupferflächen für FPCB's ("flexible printed circuit boards"): Die Breite der Leiterbahnen, die nach der Beschichtung herausgeätzt werden, wird bei steigender Integrationsdichte immer geringer. Damit kann ein einziges Staubkorn schon eine Leiterbahn unterbrechen.
b) Flexible IC's: Mittlerweile gibt es Verfahren zur Erzeugung von gedruckten Schaltungen auf Folien. Dies dient beispielsweise zur Anordnung von Bildschirmtreibern direkt auf der Folie, neben dem flexiblen Foliendisplay. Hierbei ist die räumliche Ausdehnung der Bausteine, z.B. von Transistoren, noch geringer, und die Anforderungen an die Partikelfreiheit des Herstellprozesses wird noch zwingender.
c) Entspiegelungsschichten für Displays (AR, ARAS): Auf einem entspiegelten Display wirkt ein durch ein Staubkorn während der Beschichtung abgedeckter und damit nicht entspiegelter Bereich extrem störend, z.B. als kleiner, heller Fleck auf einem ansonsten dunklen Bildschirmbereich.

Die Lösung der gestellten Aufgabe erfolgt bei der eingangs beschriebenen Bandbeschichtunganlage erfindungsgemäss dadurch, dass die der Verschlussplatte zugekehrten Enden der mindestens einen Leitwalze und der Beschichtungswalze über Tragelemente mit Lagern an der Decke befestigt sind und dass der Raum in der Vakuumkammer unterhalb der Beschichtungswalze frei von Tragelementen gehalten ist.

Dadurch wird die gestellte Aufgabe in vollem Umfange gelöst. Insbesondere werden bei gegegeben Bandbreite und -länge eine möglichst geringe Bauhöhe und auch eine möglichst geringe Baubreite erzielt. Der Bandlaufweg ist in geöffnetem Zustand, d.h., bei ausgefahrenen Beschichtungsquellen gut einsehbar und kontrollierbar. Oberhalb der Beschichtungswalze befindet sich eine geringstmögliche Zahl von beweglichen, Partikel verursachenden Teilen. Die Anlage lässt sich gut transportieren und auch in Reinräumen beschränkter Abmessungen einsetzen. Schliesslich wird auch eine wirksame Abschottung der einzelnen Kammern gegeneinander erreicht, wobei auch Nebenwege für Strömungen über die Stirnseiten der Beschichtungswalze so weit wie möglich ausgeschaltet werden.

Es ist im Zuge weiterer Ausgestaltungen der Erfindung besonders vorteilhaft, wenn - entweder einzeln oder on Kombination - :
* die mindestens eine Leitwalze und die Beschichtungswalze mit ihren der Verschlussplatte abgekehrten Enden an der Rückwand gelagert sind,
* die mindestens eine Leitwalze und die Beschichtungswalze mit ihren der Verschlussplatte abgekehrten Enden an Tragelementen vor der Rückwand gelagert und an der Decke gehalten sind,
* der Raum unterhalb und seitlich der Beschichtungswalze durch Trennwände in mindestens zwei Teilkammern unterteilt ist und wenn die Trennwände an ihren der Beschichtungswalze zugekehrten Enden Dichtelemente besitzen, deren Krümmung dem Radius der Beschichtungswalze derart angepasst ist, dass zwischen den Dichtelementen und der Beschichtungswalze bogenförmige Dichtspalte gebildet sind,
* die Dichtelemente über Verstellmechanismen mit der jeweils zugehörigen Trennwand verbunden sind, derart, dass die Dichtspalte in radialer Richtung auf kleinstmögliche Werte einstellbar sind,
* innerhalb der Vakuumkammer auf dem Umfang der Beschichtungswalze durch Trennwände mindestens vier Teilkammern gebildet sind,
* die beiden obersten Trennwände in bezug auf die Achse nach unten hin einen Winkel zwischen 120 und 180 Grad einschliessen,
* der unterhalb der beiden obersten Trennwände liegende Teilumfang der Zarge teilzylindrisch ausgebildet ist,
* in der oberhalb der beiden obersten Trennwände liegenden Teilkammer insgesamt vier Leitwalzen angeordnet sind,
* die Trennwände an ihren der Rückwand abgekehrten Enden radial verlaufende Dichtleisten aufweisen, gegen die die Verschlussplatte zur Anlage bringbar ist,
* die Dichtleisten parallel zu ihren radialen Mittellinien verlaufende elastomere Dichtkanten aufweisen, gegen die die Verschlussplatte beim Schliessen der Vakuumkammer zur Anlage bringbar ist,
* die Beschichtungswalze eine der Verschlussplatte zugekehrte Stirnseite aufweist, vor der ein ortsfester Ringsektor angeordnet ist, der das untere Ende des Tragelements für die Beschichtungswalze auf einem Teilumfang umgreift,
* die Beschichtungwalze innerhalb der Teilkammern an ihren Enden von streifenförmigen, zylindrisch koaxial gebogenen Blenden umgeben ist, die mit engen Spalten die besagten Enden umgreifen und die Beschichtungswalze gegen eine Beschichtung ihrer nicht durch das Band bedeckten Oberflächenteile abschirmen,
* die vordere Blende eine elastomere Dichtkante aufweist, gegen die die Verschlussplatte beim Schliessen der Vakuumkammer zur Anlage bringbar ist,
* der Ringsektor sich auf dem Umfang bis zu seinen Endkanten innerhalb der vorderen Blende erstreckt,
* die Gesamthöhe der Anlage, von der Aufstellfläche ausgehend, maximal 2,5 Meter beträgt,
* die Vakuumkammer beiderseits der Beschichtungswalze je eine Seitenkammer aufweist, in welcher jeweils ein Wickeldorn für eine Abwickelwalze bzw. eine Aufwickelwalze sowie zugehörige Leitwalzen für das Band angeordnet sind,
* die Seitenkammern als Vakuumkammern ausgebildet und über schlitzförmige Spalte für den Durchtritt des Bandes mit der Teilkammer der Vakuumkammer verbunden sind,
* alle Teilkammern der Vakuumkammer und die Seitenkammern an je eine eigene Vakuumpumpe angeschlossen sind, und/oder, wenn
* die Oberseiten der Seitenkammern zumindest im wesentlichen auf der gleichen Höhe liegen wie die Decke der Vakuumkammer.

Ausführungsbeispiele des Erfindungsgegenstandes und deren Wirkungsweisen und Vorteile werden nachfolgend anhand der Figuren 1 bis 5 näher erläutert.

Es zeigen:
- Figur 1: eine perspektivische Ansicht einer geöffneten Vakuumanlage mit einer Beschichtungskammer und zwei Schleusenkammern nach dem Ausfahren des Beschichtungssystems durch Wegfahren einer Verschlusswand, jedoch ohne den Bandlaufweg,
- Figur 2: eine stark schematisierte perspektivische Darstellung einer Verschlusswand mit angebautem Beschichtungssystem, bestehend aus drei Beschichtungsquellen, gesehen aus einem etwas höheren Blickwinkel,
- Figur 3: teilweise Vertikalschnitte durch eine auseinander gefahrene Anlage nach den Figuren 1 und 2 mit zwei Bedienungspersonen,
- Figur 4: eine stark vereinfachte Frontalansicht einer geöffneten Vakuumanlage mit einer Beschichtungskammer und zwei Seitenkammern für die Aufnahme von Ab- und Aufwickelwalzen für die Bänder, jedoch ohne Verschlusswand, aber mit dem Bandlaufweg, und
- Figur 5: eine Frontalansicht analog Figur 4, jedoch mit dem Unterschied, dass die Seitenkammern gegenüber der Beschichtungskammer als Schleusenkammern ausgebildet sind.

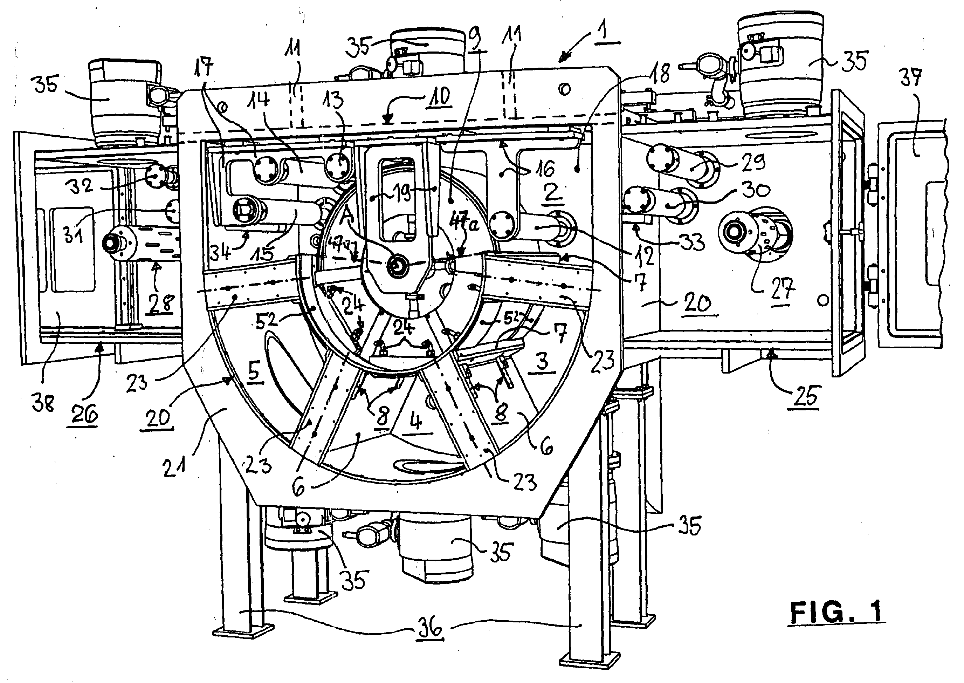

In Figur 1 ist eine Vakuumkammer 1 dargestellt, die insgesamt eine Beschichtungskammer darstellt und in vier Teilkammern 2, 3, 4 und 5 unterteilt ist. Die Teilkammern 2, 3, 4 und 5 sind mit Ausnahme von engen, bogenförmigen Spalten durch Trennwände 6 abgeschottet, von denen hier nur zwei sichtbar sind. Der radiale Verlauf in Richtung auf eine Achse A entspricht den strichpunktierten Linien. Die radial inneren Enden der Trennwände 6 sind mit bogenförmigen Dichtelementen 7 versehen, die mittels Verstellmechanismen 8 auf eine möglichst enge Spaltweite gegenüber einer Beschichtungswalze 9 einstellbar sind.

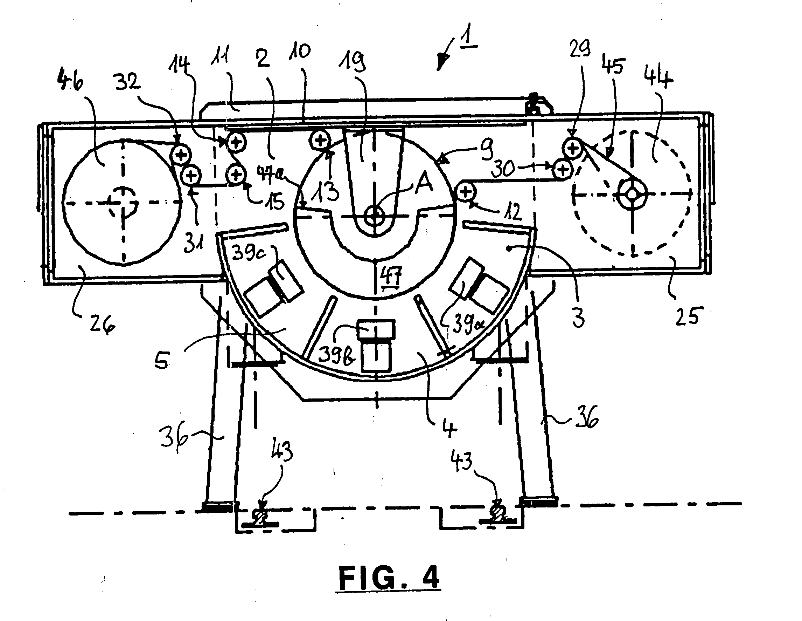

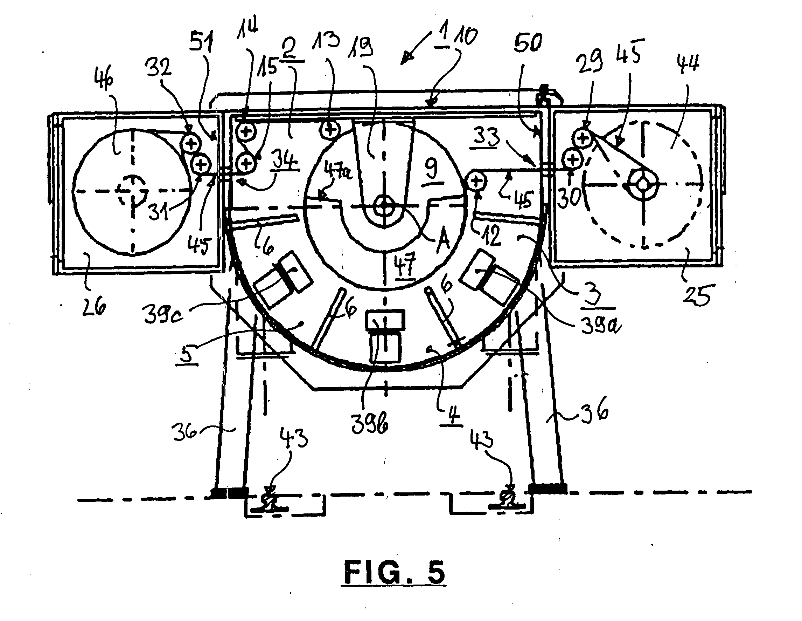

Die oberste Teilkammer 2 besitzt eine ebene Decke 10, die zusätzlich durch Stege 11 verstärkt ist. In dieser Teilkammer 2 befinden sich ausser etwa der oberen Hälfte der Beschichtungswalze 9 vier Leitwalzen 12, 13, 14 und 15, die zusammen mit der Beschichtungswalze 9 den Bandlaufweg bestimmen, was in den Figuren 4 und 5 näher dargestellt ist. Die vorderen Enden der Leitwalzen 12, 13, 14 und 15 sind in kräftigen Tragelementen 16 und 17 gelagert, die fest mit der Decke 10 verbunden, beispielsweise verschraubt, sind. Die hinteren Enden der Leitwalzen 12, 13, 14 und 15 sind mittels entsprechender Lager unmittelbar in einer Rückwand 18 gelagert, die die Vakuumkammer 1 nach hinten verschliesst. Diese Lagerung ist nur in bezug auf die Leitwalzen 12 und 15 sichtbar. Die Verbindung kann zwar lösbar ausgebildet sein, jedoch muss die Rückwand zum Bandwechsel und zur Wartung und Inspektion nicht entfernt werden.

In analoger Wese ist das vorderen Ende der Achse A der Beschichtungswalze 9 in einem stabilen Tragelement 19 gelagert, das gleichfalls fest mit der Decke 10 verbunden, beispielsweise verschraubt, ist. Das hier nicht sichtbare hintere Lager der Beschichtungswalze 9 ist wiederum in der Rückwand 18 gelagert. Dadurch ergibt sich bei kleinstmöglicher Bautiefe eine äusserst stabile Lagerung und exakte Bandführung - auch in den engen Spalten der Dichtelemente 7. Vor allem aber wird der untere Umfang der Beschichtungswalze 9 - abgesehen von den notwendigen Trennwänden 6 und ihren Dichtelementen - völlig frei von sperrigen Stützelelementen gehalten.

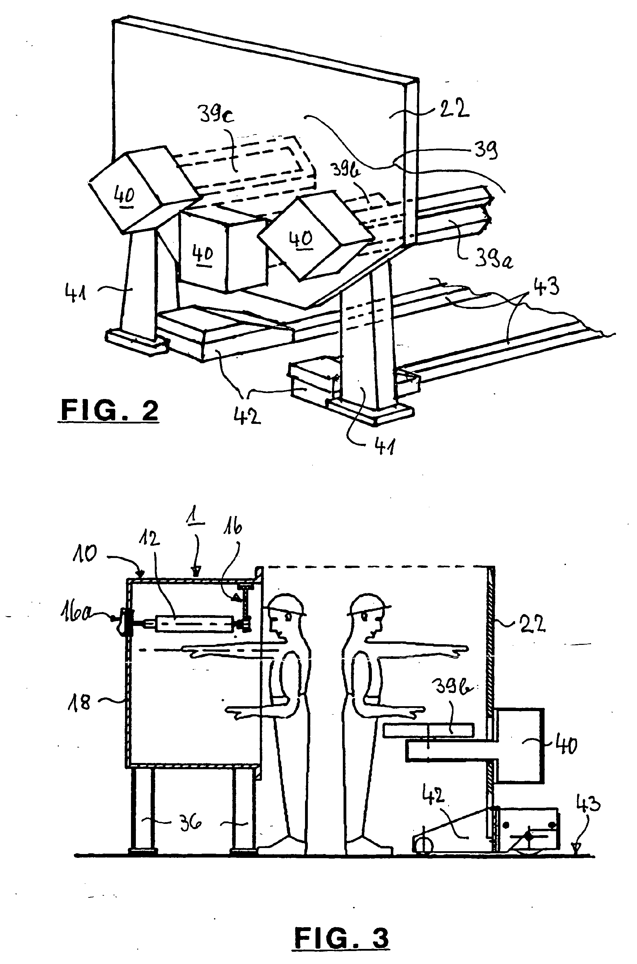

Die Vakuumkammer 1 ist von einer Zarge 20 umgeben, zu der auch die Decke 10 gehört. Auf diese Zarge ist auf der Frontseite parallel zur Rückwand 18 ein Dichtflansch 21 aufgeschweisst, dessen polygonale Umfangslinie derjenigen der Verschlussplatte 22 (siehe Figur 2) entspricht. Grob gesehen ist die untere Hälfte der Zarge 20 zylinderförmig und konzentrisch zur Achse A ausgebildet. Dadurch erhalten die Teilkammern 3, 4 und 5 mit ihren Trennwänden 6 die Form von Ringsektoren kleinstmöglichen Volumens und grösstmöglicher Festigkeit (bezogen auf die vorgegebene Bandbreite).

Um die Abdichtwirkung der Teilkammern 2, 3, 4 und 5 gegeneinander noch weiter zu verbessern sind auf die Trennwände 6 Dichtleisten 23 aufgesetzt, die durch entsprechend ausgebildete Längsränder mit nicht gezeigten elastomeren Dichtkanten an der Verschlussplatte 20 zu Anlage kommen, wenn die Vakuumkammer 1 geschlossen wird. Um dabei sogenannte Strömungkurzschlüsse über die hier sichtbare Stirnseite der Beschichtungswalze 9 kleinstmöglich zu halten, kann vor dieser Stirnseite noch ein in den Figuren 4 und 5 gezeigter Ringsektor 47 mit entsprechendem Umfangswinkel angeordnet sein. Hier sind nur die beiden oberen Endkanten 47a des Ringsektors 47 gestrichelt dargestellt.

Zur Befestigung des Ringsektors 47 sind vor der Stirnseite mehrere Winkelstücke 24 angeordnet, deren achsparallel abstehende Enden Gewinde tragen. Der entsprechend gelochte Ringsektor 47 kann auf diese Weise zwischen den Enden der Dichtleisten 23 und dem Tragelement 19 gehalten werden. Sofern dieser Ringsektor mit Kühlkanälen versehen ist, können die Winkelstücke 24 als Kühlwasserleitungen ausgeführt und an entsprechende. nicht gezeigte Leitungen angeschlossen sein. Um die nicht von dem zu beschichtenden Band abgedeckten stirnseitigen Ränder der Beschichtungswalze 9 gegen Beschichtung schützen, sind diese Ränder hinten und vorn durch Blenden 52 geschützt, die sich zwischen den Endkanten 47a auf etwas mehr als 180 Grad des Umfangs erstrecken. Innerhalb der vorderen Blende 52 liegt dann auch der besagte Ringsektor 47. An die vordere Blende 52 un eine ggf. dort vorhandene Dichtkante legt sich dann auch die Verschlussplatte 22 (Figur 2) an, so dass dann auch an dieser Stelle Strömungkurzschlüsse zwischen den Gasatmosphären der Teilkammern 3, 4 und 5 verhindert oder vermindert werden.

Im oberen Bereich der Vakuumkammer 1 sind an deren ebene Abschnitte der Zarge 20 noch zwei Seitenkammern 25 und 26 angesetzt, die in diesem Fall als Schleusenkammern ausgebildet sind. Die vorderen Verschlusswände sind der übersichtlichkeit halber weggelassen. Diese Seitenkammern 25 und 26, deren ebene Decken etwa auf gleicher Höhe liegen wie die Decke 10, sind mit beidendig gelagerten zentralen Wickeldornen 27 und 28 für die hier nicht gezeigten Ab- und Aufwickelwalzen mit den Bändern sowie mit weiteren Leitwalzen 29, 30, 31 und 32 für diese Bänder versehen. Der Banddurchtritt zur und von der Vakuumkammer 1 erfolgt durch enge schlitzförmige Spalte 33 und 34. Die Bandlaufwege sind in der Figuren 4 und 5 dargestellt. Sämtliche Teilkammern 2, 3, 4 und 5 der Vakuumkammer 1 sowie die Seitenkammern 25 und 26 sind mit eigenen Vakuumpumpen 35 versehen, so dass in jeder Teilkammer eine für die Beschichtung spezifische Atmosphäre eingestellt werden kann. Die gesamte Anordnung ruht auf einem vierbeinigen Gestell 36. Türen 37 und 38 dienen für die Beschickung und Entnahme von Ab- und Aufwickelwalzen. Mindestens ein Teil der Leitwalzen kann in Form von bekannten Streckwalzen ausgebildet sein, um eine Faltenbildung in den laufenden Bändern zu verhindern.

In Figur 2 ist stark schematisiert eine perspektivische Darstellung einer Verschlusswand 22 mit angebautem Beschichtungssystem 39, bestehend aus drei Beschichtungsquellen 39a, 39b und 39c, aus einem etwas höheren Blickwinkel als Figur 1 dargestellt. Diese Beschichtungsquellen gehen von Halterungen aus, die in drei Anschlusskästen 40 für eine erforderliche Gas- und/oder Stromversorgung untergebracht sind. Die Verschlusswand wird von zwei Säulen 41 getragen, die an Fahrgestellen 42 befestigt sind, die ihrerseits entlang von in den Boden eingelassenen Schienen 43 verfahrbar sind. Die Beschichtungsquellen und die Schienen verlaufen in Normalenrichtung zur Verschlusswand 22 und zwar in einer solchen räumlichen Ausrichtung, dass die Beschichtungsquellen 39a, 39b und 39c exakt und achsparallel in einer Position in die Teilkammern 3, 4 und 5 der Vakuumkammer 1 einfahrbar sind, wie dies in den Figuren 4 und 5 dargestellt ist.

Für die folgenden Figuren werden, soweit erforderlich, für bisher beschriebene Teile die gleichen Bezugszeichen verwendet.

Die Figur 3 zeigt teilweise Vertikalschnitte durch eine auseinander gefahrene Anlage nach den Figuren 1 und 2 mit zwei Bedienungspersonen. Links ist die Vakuumkammer 1 dargestellt, allerdings - mit Ausnahme der dort ersten Leitwalze 12 und ihrer Lagerungen - ohne alle weiteren Einbauten. Zu erkennen ist, dass die Leitwalze 12 auf der öffnungsseite mittels des Tragelements 16 an der Decke 10 befestigt und in der Rückwand 18 mittels eines Lagers 16a gelagert ist. Rechts daneben ist nur die Verschlussplatte 22 mit der mittleren Beschichtungsquelle 39b und einem der beiden Fahrgestelle 42 gezeigt. Es ist erkennbar dass die Gesamthöhe kaum grösser ist als eine erwachsene Person, wodurch sich eine solche Bauweise besonders gut für die Unterbringung in Reinräumen eignet. Bei fehlenden räumlichen Beschränkungen sind aber grössere Ausführungen durchaus denkbar.

In Figur 4 ist eine stark vereinfachte Frontalansicht einer geöffneten Vakuumanlage 1 mit einer Beschichtungskammer und zwei Seitenkammern 25 und 26 mit durchgehender Decke 10 und mit dem Bandlaufweg wie folgt dargestellt: Von einer Abwickelwalze 44, deren Anfangsdurchmesser gestrichelt dargestellt ist, wird das Band 45 über die Leitwalzen 29, 30 und 12 an die Beschichtungswalze 9 herangeführt und von dieser über die Beschichtungsquellen 39a, 39b und 39c bis zur Leitwalze 13 mitgenommen und von dort an die Leitwalzen 14, 15, 31 und 32 übergeben und schliesslich von der Aufwickelwalze 46 aufgenommen. Angedeutet ist hier der anhand von Figur 1 beschriebenen Ringsektor 47 vor der Stirn- oder Vorderseite der Beschichtungswalze 9, der die Achse A und das untere Ende des Tragelements 19 auf einem Teilumfang umgibt.

Bei dem analog dargestellten Ausführungsbeispiel nach Figur 5 sind die Seitenkammern 25 und 26 entsprechend Figur 1 bei gleichem Bandlaufweg gegenüber der Beschichtungskammer als Schleusenkammern ausgebildet, und zwar durch die Anordnung von Trennwänden 50 und 51, in denen die schlitzförmigen Spalte 33 und 34 gemäss Figur 1 für die Durchführung des Bandes 45 angeordnet sind.

### Bezugszeichenliste:

- 1: Vakuumkammer
- 2: Teilkammer
- 3: Teilkammer
- 4: Teilkammer
- 5: Teilkammer
- 6: Trennwände
- 7: Dichtelemente
- 8: Verstellmechanismen
- 9: Beschichtungswalze
- 10: Decke
- 11: Stege
- 12: Leitwalze
- 13: Leitwalze
- 14: Leitwalze
- 15: Leitwalze
- 16: Tragelement
- 16a: Lager
- 17: Tragelement
- 18: Rückwand
- 19: Tragelement
- 20: Zarge
- 21: Dichtflansch
- 22: Verschlussplatte
- 23: Dichtleisten
- 24: Winkelstücke
- 25: Seitenkammer
- 26: Seitenkammer
- 27: Wickeldorn
- 28: Wicjekldorn
- 29: Leitwalze
- 29: Leitwalze
- 30: Leitwalze
- 31: Leitwalze
- 32: Leitwalze
- 33: Spalt
- 34: Spalt
- 35: Vakuumpumpen
- 36: Gestell
- 37: Tür
- 38: Tür
- 39: Beschichtungssystem
- 39a: Beschichtungsquelle
- 39b: Beschichtungsquelle
- 39c: Beschichtungsquelle
- 40: Anschlusskästen
- 41: Säulen
- 42: Fahrgestelle
- 43: Schienen
- 44: Abwickelwalze
- 45: Band
- 46: Aufwickelwalze
- 47: Ringsektor
- 47a: Endkanten
- 50: Trennwand
- 51: Trennwand
- 52: Blenden

- A: Achse

## Patentansprüche

1. Bandbeschichtungsanlage mit einer Vakuumkammer (1), die zwischen einer Rückwand (18) und mindestens einer abnehmbaren Verschlussplatte (22) eine Zarge (20) mit einer ebenen Decke (10) besitzt, wobei in der Vakuumkammer (1) mindestens eine Leitwalze (12, 13, 14, 15) und eine Beschichtungswalze (9) mit einer Achse (A) sowie mindestens eine Beschichtungsquelle (39a, 39b, 39c) angeordnet sind, **dadurch gekennzeichnet, dass** die der Verschlussplatte (22) zugekehrten Enden der mindestens einen Leitwalze (12, 13, 14, 15) und der Beschichtungswalze (9) über Tragelemente (16, 17 und 19) mit Lagern an der Decke (10) befestigt sind und dass der Raum in der Vakuumkammer (1) unterhalb der Beschichtungswalze (9) frei von Tragelementen gehalten ist.

2. Bandbeschichtungsanlage nach Anspruch 1, **dadurch gekennzeichnet, dass** die mindestens eine Leitwalze (12, 13, 14, 15) und die Beschichtungswalze (9) mit ihren der Verschlussplatte (22) abgekehrten Enden an der Rückwand (18) gelagert sind.

3. Bandbeschichtungsanlage nach Anspruch 1, **dadurch gekennzeichnet, dass** die mindestens eine Leitwalze (12, 13, 14, 15) und die Beschichtungswalze (9) mit ihren der Verschlussplatte (22) abgekehrten Enden an Tragelementen vor der Rückwand (18) gelagert und an der Decke (10) gehalten sind.

4. Bandbeschichtungsanlage nach Anspruch 1, **dadurch gekennzeichnet, dass** der Raum unterhalb und seitlich der Beschichtungswalze (9) durch Trennwände (6) in mindestens zwei Teilkammern (3, 4, 5) unterteilt ist und dass die Trennwände (6) an ihren der Beschichtungswalze (9) zugekehrten Enden Dichtelemente (7) besitzen, deren Krümmung dem Radius der Beschichtungswalze (9) derart angepasst ist, dass zwischen den Dichtelementen (7) und der Beschichtungswalze (9) bogenförmige Dichtspalte gebildet sind.

5. Bandbeschichtungsanlage nach Anspruch 4, **dadurch gekennzeichnet, dass** die Dichtelemente (7) über Verstellmechanismen (8) mit der jeweils zugehörigen Trennwand (6) verbunden sind, derart, dass die Dichtspalte in radialer Richtung auf kleinstmögliche Werte einstellbar sind.

6. Bandbeschichtungsanlage nach Anspruch 1, **dadurch gekennzeichnet, dass** innerhalb der Vakuumkammer (1) auf dem Umfang der Beschichtungswalze (9) durch Trennwände (6) mindestens vier Teilkammern (2, 3, 4, 5) gebildet sind.

7. Bandbeschichtungsanlage nach mindestens einem der Ansprüche 1 bis 6, **dadurch gekennzeichnet, dass** die beiden obersten Trennwände (6) in bezug auf die Achse (A) nach unten hin einen Winkel zwischen 120 und 180 Grad einschliessen.

8. Bandbeschichtungsanlage nach mindestens einem der Ansprüche 1 bis 7, **dadurch gekennzeichnet, dass** der unterhalb der beiden obersten Trennwände (6) liegende Teilumfang der Zarge (20) teilzylindrisch ausgebildet ist.

9. Bandbeschichtungsanlage nach Anspruch 8, **dadurch gekennzeichnet, dass** in der oberhalb der beiden obersten Trennwände (6) liegenden Teilkammer (2) insgesamt vier Leitwalzen (12, 13, 14, 15) angeordnet sind.

10. Bandbeschichtungsanlage nach mindestens einem der Ansprüche 1 bis 9, **dadurch gekennzeichnet, dass** die Trennwände (6) an ihren der Rückwand (18) abgekehrten Enden radial verlaufende Dichtleisten (23) aufweisen, gegen die die Verschlussplatte (22) zur Anlage bringbar ist.

11. Bandbeschichtungsanlage nach Anspruch 10, **dadurch gekennzeichnet, dass** die Dichtleisten (23) parallel zu ihren radialen Mittellinien verlaufende elastomere Dichtkanten aufweisen, gegen die die Verschlussplatte (22) beim Schließen der Vakuumkammer (1) zur Anlage bringbar ist.

12. Bandbeschichtungsanlage nach Anspruch 11, **dadurch gekennzeichnet, dass** die Beschichtungswalze (9) eine der Verschlussplatte (22) zugekehrte Stirnseite aufweist, vor der ein ortsfester Ringsektor (47) angeordnet ist, der das untere Ende des Tragelements (19) für die Beschichtungswalze (9) auf einem Teilumfang umgreift.

13. Bandbeschichtungsanlage nach mindestens einem der Ansprüch 1 bis 12, **dadurch gekennzeichnet, dass** die Beschichtungwalze (9) innerhalb der Teilkammern (3 ,4 5) an ihren Enden von streifenförmigen, zylindrisch koaxial gebogenen Blenden (52) umgeben ist, die mit engen Spalten die besagten Enden umgreifen und die Beschichtungswalze (9) gegen eine Beschichtung ihrer nicht durch das Band (45) bedeckten Oberflächenteile abschirmen.

14. Bandbeschichtungsanlage nach Anspruch 13, **dadurch gekennzeichnet, dass** die vordere Blende (52) eine elastomere Dichtkante aufweist, gegen die die Verschlussplatte (22) beim Schließen der Vakuumkammer (1) zur Anlage bringbar ist.

15. Bandbeschichtungsanlage nach den Ansprüchen 13 und 14, **dadurch gekennzeichnet, dass** der Ringsektor (47) sich auf dem Umfang bis zu seinen Endkanten (47a) innerhalb der vorderen Blende (52) erstreckt.

16. Bandbeschichtungsanlage nach mindestens einem der Ansprüche 1 bis 15, **dadurch gekennzeichnet, dass** die Gesamthöhe der Anlage, von der Aufstellfläche ausgehend, maximal 2,5 Meter beträgt.

17. Bandbeschichtungsanlage nach mindestens einem der Ansprüche 1 bis 16, **dadurch gekennzeichnet, dass** die Vakuumkammer (1) beiderseits der Beschichtungswalze (9) je eine Seitenkammer (25, 26) aufweist, in welcher jeweils ein Wickeldorn (27 bzw. 28) für eine Abwickelwalze (44) bzw. eine Aufwickelwalze (46) sowie zugehörige Leitwalzen (29, 30 bzw. 31,32) für das Band (45) angeordnet sind.

18. Bandbeschichtungsanlage nach Anspruch 11, **dadurch gekennzeichnet, dass** die Seitenkammern (25, 26) als Vakuumkammern ausgebildet und über schlitzförmige Spalte (33, 34) für den Durchtritt des Bandes (45) mit der Teilkammer (2) der Vakuumkammer (1) verbunden sind.

19. Bandbeschichtungsanlage nach mindestens einem der Ansprüche 1 bis 12, **dadurch gekennzeichnet, dass** alle Teilkammern (2, 3, 4, 5) der Vakuumkammer (1) und die Seitenkammern (25, 26) an je eine eigene Vakuumpumpe (35) angeschlossen sind.

20. Bandbeschichtungsanlage nach mindestens einem der Ansprüche 17 bis 19, **dadurch gekennzeichnet, dass** die Oberseiten der Seitenkammern (25, 26) zumindest im wesentlichen auf der gleichen Höhe liegen wie die Decke (10) der Vakuumkammer (1).

## Claims

1. Strip coating installation with a vacuum chamber (1) which has, between a rear wall (18) and at least one removable closing plate (22), a casing (20) with a flat top (10), wherein at least one guide roller (12, 13, 14, 15) and a coating roller (9) with an axis (A), and at least one coating source (39a, 39b, 39c), are positioned inside the vacuum chamber (1),
**characterised in that**
the ends of the at least one guide roller (12, 13, 14, 15) and of the coating roller (9) that face towards the closing plate (22) are attached by means of supporting elements (16, 17 and 19) and with bearings to the top (10), and **in that** the space in the vacuum chamber (1) beneath the coating roller (9) is kept free of supporting elements.

2. Strip coating installation as in claim 1,
**characterised in that**
the at least one guide roller (12, 13, 14, 15) and the coating roller (9) are mounted, at their ends that face away from the closing plate (22), on bearings on the rear wall (18).

3. Strip coating installation as in claim 1,
**characterised in that**
the at least one guide roller (12, 13, 14, 15) and the coating roller (9) are, at their ends that face away from the closing plate (22), mounted on bearings on supporting elements in front of the rear wall (18) and held on the top (10).

4. Strip coating installation as in claim 1,
**characterised in that**
the space beneath and at the side of the coating roller (9) is divided by means of partitions (6) into at least two chamber sections (3, 4, 5), and **in that** the partitions (6) have sealing elements (7) at their ends that face towards the coating roller (9), the curvature of which elements is made to fit the radius of the coating roller (9) in such a manner that curved sealing gaps are formed between the sealing elements (7) and the coating roller (9).

5. Strip coating installation as in claim 4,
**characterised in that**
each of the sealing elements (7) is connected to its accompanying partition (6) by means of an adjustment mechanism (8) in such a manner that the sealing gaps can be adjusted to the smallest possible size in a radial direction.

6. Strip coating installation as in claim 1,
**characterised in that**,
inside the vacuum chamber (1), at least four chamber sections (2, 3, 4, 5) are formed on the circumference of the coating roller (9) by means of partitions (6).

7. Strip coating installation as in at least one of claims 1 to 6,
**characterised in that**
the two uppermost partitions (6) enclose an angle of between 120 and 180 degrees downwards in relation to the axis (A).

8. Strip coating installation as in at least one of claims 1 to 7,
**characterised in that**
the circumferential section of the casing (20) that is beneath the two uppermost partitions (6) is made in the shape of a part-cylinder.

9. Strip coating installation as in claim 8,
**characterised in that**,
in the chamber section (2) that is above the two uppermost partitions (6), there are positioned a total of four guide rollers (12, 13, 14, 15).

10. Strip coating installation as in at least one of claims 1 to 9,
**characterised in that**
the partitions (6) have, at their ends that face away from the rear wall (18), radial sealing strips (23) against which the closing plate (22) can be brought to rest.

11. Strip coating installation as in claim 10,
**characterised in that**
the sealing strips (23) have elastomeric sealing edges that run parallel to their radial centre lines, against which edges the closing plate (22) can be brought to rest when the vacuum chamber (1) is closed.

12. Strip coating installation as in claim 11,
**characterised in that**
the coating roller (9) has an end face that faces towards the closing plate (22), in front of which face is positioned a fixed ring sector (47) which encloses the lower end of the supporting element (19) for the coating roller (9) around part of the circumference.

13. Strip coating installation as in at least one of claims 1 to 12,
**characterised in that**
the coating roller (9) is surrounded at its ends, inside the chamber sections (3, 4, 5), by strip-shaped screens (52) that are curved cylindrically and coaxially, which screens enclose the said ends with narrow gaps and shield the coating roller (9) from being coated on its surfaces that are not covered by the strip (45).

14. Strip coating installation as in claim 13,
**characterised in that** the front screen (52) has an elastomeric sealing edge against which the closing plate (22) can be brought to rest when the vacuum chamber (1) is closed.

15. Strip coating installation as in claims 13 and 14,
**characterised in that** the ring sector (47) extends over the circumference as far as its end edges (47a) inside the front screen (52).

16. Strip coating installation as in at least one of claims 1 to 15,
**characterised in that** the overall height of the installation, measured from the surface on which it is mounted, is a maximum of 2.5 metres.

17. Strip coating installation as in at least one of claims 1 to 16,
**characterised in that**
the vacuum chamber (1) has, on each of the two sides of the coating roller (9), a side chamber (25, 26), in each of which are positioned a winding spindle (27, 28 respectively) for an off-winding roller (44) and a take-up roller (46) respectively, and accompanying guide rollers (29, 30 and 31, 32 respectively) for the strip (45).

18. Strip coating installation as in claim 11,
**characterised in that** the side chambers (25, 26) are in the form of vacuum chambers and are linked to the chamber section (2) of the vacuum chamber (1) by means of slot-shaped gaps (33, 34) for the strip (45) to pass through.

19. Strip coating installation as in at least one of claims 1 to 12,
**characterised in that** each of the chamber sections (2, 3, 4, 5) of the vacuum chamber (1) and the side chambers (25, 26) is connected to a vacuum pump (35) of its own.

20. Strip coating installation as in at least one of claims 17 to 19,
**characterised in that**
the top surfaces of the side chambers (25, 26) are at least essentially positioned at the same height as the top (10) of the vacuum chamber (1).

## Revendications

1. Installation de revêtement de bandes comportant une chambre sous vide (1) qui, entre une paroi arrière (18) et au moins une plaque de fermeture (22) amovible, comporte un châssis (20) avec une paroi supérieure (10) plane, sachant qu'au moins un cylindre de guidage (12, 13, 14, 15) et un cylindre de revêtement (9) avec un axe (A), ainsi qu'au moins une source de revêtement (39a, 39b, 39c) sont montés dans la chambre sous vide (1), **caractérisée en ce que** ledit au moins un cylindre de guidage (12, 13, 14, 15) et le cylindre de revêtement (9), au niveau de leurs extrémités orientées vers la plaque de fermeture (22), sont fixées avec des paliers contre la paroi supérieure (10) par l'intermédiaire d'éléments de support (16, 17 et 19), et **en ce que** l'espace à l'intérieur de la chambre sous vide (1) en dessous du cylindre de revêtement (9) ne comporte aucun élément de support.

2. Installation de revêtement de bandes selon la revendication 1, **caractérisée en ce que** ledit au moins un cylindre de guidage (12, 13, 14, 15) et le cylindre de revêtement (9) sont montés, avec leurs extrémités opposées à la plaque de fermeture (22), contre la paroi arrière (18).

3. Installation de revêtement de bandes selon la revendication 1, **caractérisée en ce que** ledit au moins un cylindre de guidage (12, 13, 14, 15) et le cylindre de revêtement (9) sont montés, avec leurs extrémités opposées à la plaque de fermeture (22), sur des éléments de support devant la paroi arrière (18) et sont fixés contre la paroi supérieure (10).

4. Installation de revêtement de bandes selon la revendication 1, **caractérisée en ce que** l'espace en dessous et à côté du cylindre de revêtement (9) est subdivisé par des cloisons (6) en au moins deux chambres partielles (3, 4, 5) et **en ce que** les cloisons (6), au niveau de leurs extrémités orientées vers le cylindre de revêtement (9), comportent des éléments d'étanchéité (7) dont la courbure est adaptée au rayon du cylindre de revêtement (9), de telle sorte qu'il se forme des fentes d'étanchéité cintrées entre les éléments d'étanchéité (7) et le cylindre de revêtement (9).

5. Installation de revêtement de bandes selon la revendication 4, **caractérisée en ce que** les éléments d'étanchéité (7) sont assemblés à la cloison (6) respectivement correspondante par des mécanismes de réglage (8), de telle sorte que les fentes d'étanchéité peuvent être réglées aux plus petites valeurs possibles dans le sens radial.

6. Installation de revêtement de bandes selon la revendication 1, **caractérisée en ce qu'**au moins quatre chambres partielles (2, 3, 4, 5) sont formées au moyen de cloisons (6) sur le pourtour du cylindre de revêtement (9) à l'intérieur de la chambre sous vide (1).

7. Installation de revêtement de bandes selon au moins l'une quelconque des revendications 1 à 6, **caractérisée en ce que** les deux cloisons (6) supérieures forment vers le bas par rapport à l'axe (A) un angle entre 120 et 180 degrés.

8. Installation de revêtement de bandes selon au moins l'une quelconque des revendications 1 à 7, **caractérisée en ce que** la partie du pourtour du châssis (20), située en dessous des deux cloisons (6) supérieures, est partiellement cylindrique.

9. Installation de revêtement de bandes selon la revendication 8, **caractérisée en ce qu'**au total quatre cylindres de guidage (12, 13, 14, 15) sont agencés dans la chambre partielle (2) située au-dessus des deux cloisons (6) supérieures.

10. Installation de revêtement de bandes selon au moins l'une quelconque des revendications 1 à 9, **caractérisée en ce que** les cloisons (6), au niveau de leurs extrémités opposées à la paroi arrière (18), comportent des baguettes d'étanchéité (23) orientées radialement, contre lesquelles la plaque de fermeture (22) peut être amenée en appui.

11. Installation de revêtement de bandes selon la revendication 10, **caractérisée en ce que** les baguettes d'étanchéité (23) comportent des bords d'étanchéité élastomères, parallèles à leurs axes médians radiaux, contre lesquels la plaque de fermeture (22) peut être amenée en appui lors de la fermeture de chambre sous vide (1).

12. Installation de revêtement de bandes selon la revendication 11, **caractérisée en ce que** le cylindre de revêtement (9) comporte une face frontale, qui est orientée vers la plaque de fermeture (22) et devant laquelle est agencé un secteur annulaire (47) fixe, qui entoure sur une partie du pourtour l'extrémité inférieure de l'élément de support (19) pour le cylindre de revêtement (9).

13. Installation de revêtement de bandes selon au moins l'une quelconque des revendications 1 à 12, **caractérisée en ce que** le cylindre de revêtement (9), à l'intérieur des chambres partielles (3, 4, 5), est entouré au niveau de ses extrémités par des caches (52) en forme de bandes, courbés coaxialement avec une forme cylindrique, qui entourent lesdites extrémités avec des fentes étroites et qui empêchent que le cylindre de revêtement (9) soit revêtu dans ses parties de surface non couvertes par la bande (45).

14. Installation de revêtement de bandes selon la revendication 13, **caractérisée en ce que** le cache avant (52) comporte un bord d'étanchéité élastomère, contre lequel la plaque de fermeture (22) peut être amenée en appui lors de la fermeture de chambre sous vide (1).

15. Installation de revêtement de bandes selon les revendications 13 et 14, **caractérisée en ce que** le secteur annulaire (47) s'étend sur le pourtour jusqu'à ses bords d'extrémité (47a) à l'intérieur du cache avant (52).

16. Installation de revêtement de bandes selon au moins l'une quelconque des revendications 1 à 15, **caractérisée en ce que** la hauteur totale de l'installation à partir de la surface de pose mesure au maximum 2,5 mètres.

17. Installation de revêtement de bandes selon au moins l'une quelconque des revendications 1 à 16, **caractérisée en ce que** la chambre sous vide (1) comporte, de part et d'autre du cylindre de revêtement (9), respectivement une chambre latérale (25, 26), dans laquelle sont agencés respectivement un mandrin d'enroulement (27 et 28) pour un rouleau de déroulement (44) ou un rouleau d'enroulement (46), ainsi que des cylindres de guidage (29, 30 et 31, 32) correspondants pour la bande (45).

18. Installation de revêtement de bandes selon la revendication 11, **caractérisée en ce que** les chambres latérales (25, 26) sont réalisées sous forme de chambres sous vide et communiquent avec la chambre partielle (2) de la chambre sous vide (1) par l'intermédiaire d'interstices (33, 34) en forme de fentes pour le passage de la bande (45).

19. Installation de revêtement de bandes selon au moins l'une quelconque des revendications 1 à 12, **caractérisée en ce que** toutes les chambres partielles (2, 3, 4, 5) de la chambre sous vide (1) et les chambres latérales (25, 26) sont raccordées à leur propre pompe à vide (35).

20. Installation de revêtement de bandes selon au moins l'une quelconque des revendications 17 à 19, **caractérisée en ce que** les faces supérieures des chambres latérales (25, 26) sont situées au moins sensiblement à la même hauteur que la paroi supérieure (10) de la chambre sous vide (1).
